# EUROPEAN PATENT APPLICATION

(11) **EP 2 704 188 A2**
(43) Date of publication of application: **05.03.2014**
(21) Application number: 13182287.6
(22) Date of filing: 29.08.2013
(51) Int. Cl.: H01L 21/8238, H01L 27/092

(54) **Semiconductor device and method of fabricating the same**

(30) Priority: 31.08.2012 KR 20120096611
(71) Applicant: Samsung Electronics Co., Ltd, Gyeonggi-do 443-742 (KR)
(72) Inventor: Kim, Ju-Youn, Suwon-si, Gyeonggi-do 443-707 (KR); Kim, Bong-Seok, Seongnam-si, Gyeonggi-do 463-747 (KR); Maeda, Shigenobu, Seongnam-si, Gyeonggi-do 463-010 (KR)
(74) Representative: Kuhnen & Wacker

(57) **Abstract**

A semiconductor device comprises: a semiconductor substrate (100) comprising a first region (I) and a second region (II); and first (TR1) and second (TR2) transistors on the first and second regions, respectively, wherein the first transistor comprises a first gate insulating layer pattern (132), the second transistor comprises a second gate insulating layer pattern (134), the first and second transistors both comprise a work function adjustment film pattern (142) and a gate metal pattern (162), wherein the work function adjustment film pattern (142) of the first transistor comprises the same material as the work function adjustment film pattern (142) of the second transistor and the gate metal pattern (162) of the first transistor comprises the same material as gate metal pattern (162) of the second transistor, and a concentration of a metal contained in the first gate insulating layer pattern (132) to adjust a threshold voltage of the first transistor is different from a concentration of the metal contained in the second gate insulating layer pattern (134) to adjust a threshold voltage of the second transistor.

## Description

This application claims priority from Korean Patent Application No. 10-2012-0096611 filed on August 31, 2012, in the Korean Intellectual Property Office, the contents of which are herein incorporated by reference in their entirety.

### BACKGROUND

### 1. Field of the Invention

The present inventive concepts relate to a semiconductor device and a method of fabricating the same.

### 2. Description of the Related Art

As a feature size of transistors is reduced, a gate and a channel formed under the gate are becoming shorter. Therefore, methods to increase the capacitance between the gate and the channel and improve operating characteristics of the transistors are being developed.

One of these methods includes adjusting a threshold voltage (Vt) by controlling a work function of a transistor. The work function of the transistor may be controlled by, for example, implanting ions into a channel region of the transistor. However, as the feature size of transistors is reduced and a shape of transistors becomes three-dimensional, it is becoming difficult to control the distribution of implanted ions.

### SUMMARY

Aspects of the present inventive concepts provide a semiconductor device in which a threshold voltage (Vt) of a transistor can be adjusted easily.

Aspects of the present inventive concepts also provide a method of fabricating a semiconductor device in which a threshold voltage of a transistor can be adjusted easily.

However, aspects of the present inventive concepts are not restricted to the one set forth herein. The above and other aspects of the present inventive concepts will become more apparent to one of ordinary skill in the art to which the present inventive concepts pertains by referencing the detailed description of the present inventive concepts given below.

According to an aspect of the present inventive concepts, there is provided a semiconductor device comprising: a semiconductor substrate comprising a first region and a second region; and first and second transistors on the first and second regions, respectively, wherein the first transistor comprises a first gate insulating layer pattern, the second transistor comprises a second gate insulating layer pattern, the first and second transistors both comprise a work function adjustment film pattern and a gate metal pattern, wherein the work function adjustment film pattern of the first transistor comprises the same material as the work function adjustment film pattern of the second transistor and the gate metal pattern of the first transistor comprises the same material as gate metal pattern of the second transistor, and a concentration of a metal contained in the first gate insulating layer pattern to adjust a threshold voltage of the first transistor is different from a concentration of the metal contained in the second gate insulating layer pattern to adjust a threshold voltage of the second transistor.

In some embodiments, the metal comprises La or Al.

In some embodiments, the metal does not exist in the first gate insulating layer pattern and exists in the second gate insulating layer pattern.

In some embodiments, the work function adjustment film patterns of the first and second transistors comprise a metal nitride. In some embodiments, the metal nitride comprises TiN.

In some embodiments, the work function adjustment film pattern of the first transistor contacts the first gate insulating layer pattern and the gate metal pattern of the first transistor and the work function adjustment film pattern of the second transistor contacts the second gate insulating layer pattern and the gate metal pattern of the second transistor.

In some embodiments, the first transistor and the second transistor have different conductivity types. In some embodiments, the first transistor and the second transistor have the same threshold voltage.

In some embodiments, the first transistor and the second transistor have the same conductivity type, and the threshold voltage of the second transistor is higher than that of the first transistor. In some embodiments, the first gate insulating layer pattern is thinner than the second gate insulating layer pattern.

In some embodiments, the gate metal patterns of the first and second transistors comprise a conductive pattern and a barrier pattern. In some embodiments, the conductive pattern comprises Al.

In some embodiments, the semiconductor device further comprises a first fin formed in the first region and a second fin formed in the second region, wherein the first and second transistors are on the first and second fins, respectively.

According to another aspect of the present inventive concepts, there is provided a semiconductor device comprising: a semiconductor substrate comprising a first region and a second region; and first and second transistors having the same conductivity type and on the first and second regions, respectively, wherein the first transistor comprises a first gate insulating layer pattern, a first work function adjustment film pattern and a first gate metal pattern formed sequentially on the semiconductor substrate, the second transistor comprises a second gate insulating layer pattern, a second work function adjustment film pattern and a second gate metal pattern formed sequentially on the semiconductor substrate, wherein the first gate insulating layer pattern and the second gate insulating layer pattern have different thicknesses.

In some embodiments, a concentration of a metal contained in the first gate insulating layer pattern to adjust a threshold voltage of the first transistor is different from a concentration of the metal contained in the second gate insulating layer pattern to adjust a threshold voltage of the second transistor.

In some embodiments, the semiconductor device further comprises a third transistor on a third region of the semiconductor substrate, wherein the third transistor comprises a third gate insulating layer pattern, a third work function adjustment film pattern and a third gate metal pattern formed sequentially on the semiconductor substrate, wherein a thickness of the third gate insulating layer pattern is different from the thicknesses of the first and second gate insulating layer patterns.

In some embodiments, a concentration of the metal contained in the third gate insulating layer pattern to adjust a threshold voltage of the third transistor is different from the concentration of the metal contained in each of the first and second gate insulating layer patterns to adjust the threshold voltage of each of the first and second transistors.

In some embodiments, a conductivity type of the third transistor is the same as those of the first and second transistors, the threshold voltage of the third transistor is higher than that of the second transistor, and the threshold voltage of the second transistor is higher than that of the first transistor.

In some embodiments, the conductivity type of the third transistor is different from those of the first and second transistors, the threshold voltage of the third transistor is the same as that of the second transistor, and the threshold voltage of the second transistor is higher than that of the first transistor.

According to another aspect of the present inventive concepts, there is provided a method of fabricating a semiconductor device, the method comprising: providing a semiconductor substrate which comprises first, second and third regions and first, second, and third gate insulating layers which are on the first, second and third regions, respectively; forming a first diffusion prevention film, which exposes the second and third gate insulating layers, on the semiconductor substrate; sequentially forming a first diffusion film, which comprises a metal oxide, and a first protection film on the semiconductor substrate; diffusing a metal contained in the first diffusion film to the second and third gate insulating layers by performing a first heat treatment process on the semiconductor substrate; removing the first diffusion film, the first protection film and the first diffusion prevention film; forming a second diffusion prevention film, which exposes the third gate insulating layer, on the semiconductor substrate; sequentially forming a second diffusion film, which comprises a metal oxide, and a second protection film on the semiconductor substrate; and diffusing a metal contained in the second diffusion film to the third gate insulating layer by performing a second heat treatment process on the semiconductor substrate.

In some embodiments, the first and second diffusion prevention films comprise a metal oxide. In some embodiments, the metal nitride comprises TiN.

In some embodiments, the first and second protection films prevent oxidation of the first and second diffusion films during the first and second heat treatment processes.

According to another aspect of the present inventive conceptes, there is provided a method of fabricating a semiconductor device, the method comprising: providing a semiconductor substrate which comprises first, second and third regions and first, second and third gate insulating layers which are on the first, second and third regions, respectively; forming a diffusion prevention film, which exposes the second and third gate insulating layers, on the semiconductor substrate; sequentially forming a diffusion film, which comprises a metal oxide, and a protection film on the semiconductor substrate; and diffusing a metal contained in the diffusion film to the second and third gate insulating layers by heat-treating the semiconductor substrate, wherein a first thickness of the diffusion film on the second gate insulating layer is different from a second thickness of the diffusion film on the third gate insulating layer.

In some embodiments, the second thickness is greater than the first thickness. In some embodiments, a concentration of the metal diffused to the second gate insulating layer is smaller than that of the metal diffused to the third gate insulating layer.

According to another aspect of the present inventive concepts, there is provided a method of fabricating a semiconductor device, the method comprising: providing a first transistor comprising a first gate insulating layer pattern, a first work function adjustment film pattern and a first gate metal pattern and having a first threshold voltage; providing a second transistor comprising a second gate insulating layer pattern, a second work function adjustment film pattern and a second gate metal pattern; determining an amount of metal that should be diffused to the second gate insulating layer pattern in order to adjust a threshold voltage of the second transistor; and adjusting the threshold voltage of the second transistor by masking the first gate insulating layer patternand then diffusing the determined amount of metal only to the second gate insulating layer pattern through a heat treatment process.

In some embodiments, the method further comprises measuring an initial threshold voltage of the second transistor and determining a target threshold voltage of the second transistor, wherein the determining of the amount of metal that should be diffused to the second gate insulating layer pattern comprises determining the amount of metal that should be diffused to the second gate insulating layer pattern in order to adjust the threshold voltage of the second transistor from the initial threshold voltage to the target threshold voltage.

According to another aspect of the present inventive concepts, there is provided a semiconductor device comprising: a semiconductor substrate comprising a first region and a second region, a first transistor on the first region comprising a first gate insulating layer pattern, and a second transistor on the second region comprising a second gate insulating layer pattern. A concentration of a metal in the second gate insulating layer pattern is higher than a concentration of metal in the first gate insulating layer pattern.

In some embodiments, the first and second transistors both further comprise a work function adjustment film pattern and a gate metal pattern, the work function adjustment film pattern of the first transistor being patterned from a same layer as the work function adjustment film pattern of the second transistor and the gate metal pattern of the first transistor being patterned from a same layer as the gate metal pattern of the second transistor.

In some embodiments, the metal does not exist in the first gate insulating layer pattern and exists in the second gate insulating layer pattern.

In some embodiments, the first transistor and the second transistor have different conductivity types.

In some embodiments, the first transistor and the second transistor have the same conductivity type, and the threshold voltage of the second transistor is higher than that of the first transistor.

### BRIEF DESCRIPTION OF THE DRAWINGS

The foregoing and other features and advantages of the inventive concepts will be apparent from the more particular description of embodiments of the inventive concepts, as illustrated in the accompanying drawings in which like reference characters refer to the same parts throughout the different views. The drawings are not necessarily to scale, emphasis instead being placed upon illustrating the principles of the inventive concepts.

FIG. 1 is a cross-sectional view of a semiconductor device according to an embodiment of the present inventive concepts.

FIG. 2 is a flowchart illustrating a method of fabricating a semiconductor device according to an embodiment of the present inventive concepts.

FIG. 3 is a cross-sectional view, FIG. 4 is a graph and FIGs. 5A and 5B are cross-sectional views illustrating a method of fabricating the semiconductor device of FIG. 1 according to an embodiment of the present inventive concepts.

FIG. 6 is a cross-sectional view of a semiconductor device according to another embodiment of the present inventive concepts.

FIG. 7 is a view illustrating a method of fabricating the semiconductor device of FIG. 6 according to an embodiment of the present inventive concepts.

FIG. 8 is a cross-sectional view of a semiconductor device according to another embodiment of the present inventive concepts.

FIG. 9 is a cross-sectional view of a semiconductor device according to another embodiment of the present inventive concepts.

FIG. 10 is a cross-sectional view of a semiconductor device according to another embodiment of the present inventive concepts.

FIG. 11 is a cross-sectional view of a semiconductor device according to another embodiment of the present inventive concepts.

FIGS. 12, 13A and 13B are cross-sectional views illustrating a method of fabricating a semiconductor device of FIGs. 10 and 11 according to an embodiment of the present inventive concepts.

FIG. 14 is a cross-sectional view illustrating a method of fabricating a semiconductor device according to another embodiment of the present inventive concepts.

FIG. 15 is a perspective view of a semiconductor device according to another embodiment of the present inventive concepts.

FIG. 16 is a cross-sectional view taken along line A-A' of FIG. 15.

FIG. 17 is a cross-sectional view taken along line B-B' of FIG. 15.

FIGS. 18 is a circuit diagram and FIG. 19 is a layout diagram of a semiconductor device according to another embodiment of the present inventive concepts.

FIG. 20 is a block diagram of an electronic system including semiconductor devices according to some embodiments of the present inventive concepts.

FIGS. 21 and 22 are exemplary semiconductor systems to which semiconductor devices according to some embodiments of the present inventive concepts may be applied.

### DETAILED DESCRIPTION OF THE EMBODIMENTS

Various example embodiments of the inventive concepts will be described more fully hereinafter with reference to the accompanying drawings, in which some example embodiments are shown. The present inventive concepts may, however, be embodied in many different forms and should not be construed as limited to the example embodiments set forth herein. It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

Spatially relative terms, such as "beneath," "below," "lower," "above," "upper" and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the inventive concepts. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer and/or section from another element, component, region, layer and/or section. Thus, for example, a first element, component, region layer or section discussed below could be termed a second element, component, region, layer or section without departing from the teachings of the present inventive concepts.

Example embodiments are described with reference to cross-sectional illustrations that are schematic illustrations of idealized exemplary embodiments (and intermediate structures). As such, variations from the shapes of the illustrations as a result, for example, of manufacturing techniques and/or tolerances, are to be expected. Thus, exemplary embodiments should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the present inventive concepts.

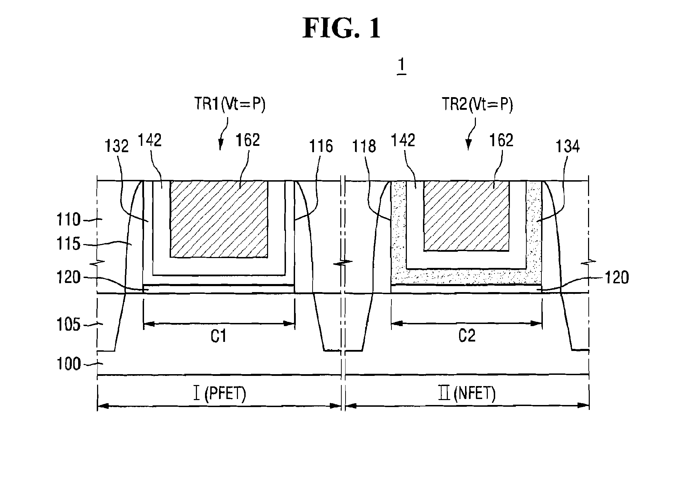

A semiconductor device according to an example embodiment of the present inventive concepts will now be described with reference to FIG. 1.

FIG. 1 is a cross-sectional view of a semiconductor device 1 according to an embodiment of the present inventive concepts.

Referring to FIG. 1, the semiconductor device 1 includes a first transistor TR1 and a second transistor TR2.

The first transistor TR1 may be formed on a first region I of a semiconductor substrate 100, and the second transistor TR2 may be formed on a second region II of the semiconductor substrate 100. In the embodiment of FIG. 1, the first region I may be a P-type field effect transistor (PFET) region in which a P-type transistor is formed, and the second region II may be an N-type field effect transistor (NFET) in which an N-type transistor is formed. That is, in the current embodiment, the first transistor TR1 may be a PFET, and the second transistor TR2 may be an NFET. However, the present inventive concepts are not limited thereto.

The first transistor TR1 may include an interface film pattern 120, a first gate insulating layer pattern 132, a work function adjustment film pattern 142, and a gate metal pattern 162 formed sequentially on a first channel region C1 which is defined in the first region I of the semiconductor substrate 100.

A device isolation film 105, such as a shallow trench isolation (STI) film, may be formed in the semiconductor substrate 100 to define the first channel region C1. The semiconductor substrate 100 may be made of one or more semiconductor materials selected from a group including Si, Ge, SiGe, GaP, GaAs, SiC, SiGeC, InAs, and InP. In some embodiments of the present inventive concepts, the semiconductor substrate 100 may be made of silicon-on-insulator (SOI).

An interlayer insulating film 110 may be formed on the semiconductor substrate 100. The interlayer insulating film 110 may include a first trench 116 formed on the first region I and a second trench 118 formed on the second region II.

A spacer 115 may be formed on both sidewalls of the first trench 116 as illustrated in FIG. 1. The spacer 115 may include at least one of a nitride film and an oxynitride film. Although not illustrated in FIG. 1, the spacer 115 may be L-shaped.

The interface film pattern 120, the first gate insulating layer pattern 132, the work function adjustment film pattern 142, and the gate metal pattern 162 may be formed sequentially in the first trench 116 to form the first transistor TR1.

The interface film pattern 120 may be formed along a bottom surface of the first trench 116 contacting the substrate 100. The interface film pattern 120 may prevent a poor interface between the semiconductor substrate 100 and the gate insulating layer pattern 132. The interface film pattern 120 may include a low- k material layer with a dielectric constant (k) of 9 or less (for example, a silicon oxide film with a dielectric constant of approximately 4) or a silicon oxynitride film with a dielectric constant of approximately 4 to 8 according to the content of oxygen atoms and nitrogen atoms. Alternatively, the interface film pattern 120 may be made of silicate or a combination of the above example films. The first gate insulating layer pattern 132 may be formed along sidewalls of the first trench 116 contacting spacers 115 and along an upper surface of the interface film pattern 120.

The first gate insulating layer pattern 132 may contain a high-k material. Specifically, the first gate insulating layer pattern 132 may comprise a material selected from the group including HfO₂, ZrO₂, Ta₂O₅, TiO₂, SrTiO₃, BaTiO₃, and SrTiO₃. The first gate insulating layer pattern 132 may be formed to an appropriate thickness according to the type of a device to be formed. For example, when the first gate insulating layer pattern 132 comprises HfO₂, it may be formed to a thickness of, but not limited to, approximately 50 Å or less (approximately 5 to 50 A).

The work function adjustment film pattern 142 of the first transistor TR1 may be formed on the first gate insulating layer pattern 132 as illustrated in FIG. 1. In some embodiments of the present inventive concepts, the work function adjustment film pattern 142 may be in contact with the first gate insulating layer pattern 132.

In some embodiments of the present inventive concepts, the work function adjustment film pattern 142 may comprise, for example, a metal nitride. Specifically, the work function adjusting film pattern 142 may comprise at least one of TiN and TaN. More specifically, the work function adjustment film pattern 142 may be, but is not limited to, a single layer of TiN or a double layer consisting of a TiN layer and a TaN layer formed on the TiN layer.

The first gate insulating layer pattern 132 and the work function adjustment film pattern 142 of the first transistor TR1 may extend upward along sidewalls of the interlayer insulating film 110. The first gate insulating layer pattern 132 and the work function adjustment film pattern 142 are formed as such because the semiconductor device 1 according to the embodiment of FIG. 1 is fabricated using a replacement metal gate (RMG) process.

The gate metal pattern 162 may be formed on the work function adjustment film pattern 142 of the first transistor TR1. In some embodiments of the present inventive concepts, the gate metal pattern 162 may be formed in contact with the work function adjustment film pattern 142 as illustrated in FIG. 1. In some embodiments of the present inventive concepts, the gate metal pattern 162 may be made of, but not limited to, a conductive metal material such as Al or W.

The second transistor TR2 may include an interface film pattern 120, a second gate insulating layer pattern 134, a work function adjustment film pattern 142, and a gate metal pattern 162 formed sequentially in the second trench 118 on a second channel region C2 which is defined in the second region II of the semiconductor substrate 100. A device isolation film 105, such as a shallow trench isolation (STI) film, may be formed in the semiconductor substrate 100 to define the second channel region C2.

That is, in the embodiment of FIG. 1 of the present inventive concepts, the second transistor TR2 may have a different conductivity type from that of the first transistor TR1. However, the second transistor TR2 and the first transistor TR1 may include the same work function adjustment film pattern 142, that is, the work function adjustment film patterns 142 of the first and second transistors TR1 and TR2 are patterned from the same layer.

A metal for adjusting a threshold voltage Vt of the second transistor TR2 may have been diffused to the second gate insulating layer pattern 134 of the second transistor TR2. Accordingly, the second gate insulating layer pattern 134 may be thicker than the first gate insulating layer pattern 132.

That is, the first and second transistors TR1 and TR2 having different conductivity types may include the same work function adjustment film pattern 142 but the gate insulating layer patterns 132 and 134 may have different concentrations of a metal diffused thereto and may have different thicknesses. In particular, in the embodiment of FIG. 1, the metal may not exist in the first gate insulating layer pattern 132 of the first transistor TR1 but may exist in the second gate insulating layer pattern 134 of the second transistor TR2, as illustrated in FIG. 1.

The metal diffused to the gate insulating layer patterns 132 and 134 may cause the second transistor TR2 to have the same threshold voltage Vt as the first transistor TR1. That is, in the embodiment of FIG. 1, the first transistor TR1 (i.e., a PFET) and the second transistor TR2 (i.e., an NFET) may have the same threshold voltage P as illustrated in FIG. 1.

As described above, the first and second transistors TR1 and TR2 having different conductivity types have the same threshold voltage even if they include the same work function adjustment film pattern 142. This may be due to a metal, for example, La or Al, diffused to the second gate insulating layer pattern 134 of the second transistor TR2. That is, in the embodiment of FIG. 1, a threshold voltage of a transistor can be adjusted by controlling the concentration of a metal diffused to a gate insulating layer pattern 132 or 134.

A spacer 115 may be formed on both sidewalls of the second trench 118 as illustrated in FIG. 1. The spacer 115 may include at least one of a nitride film and an oxynitride film. Although not illustrated in FIG. 1, the spacer 115 may be L-shaped.

The interface film pattern 120 may be formed along a bottom surface of the second trench 118 contacting the substrate 100. The interface film pattern 120 may prevent a poor interface between the semiconductor substrate 100 and the second gate insulating layer pattern 134. The interface film pattern 120 may include a low- k material layer with a dielectric constant (k) of 9 or less (for example, a silicon oxide film with a dielectric constant of approximately 4) or a silicon oxynitride film with a dielectric constant of approximately 4 to 8 according to the content of oxygen atoms and nitrogen atoms. Alternatively, the interface film pattern 120 may be made of silicate or a combination of the above example films. The second gate insulating layer pattern 134 may be formed along sidewalls of the second trench 118 contacting spacers 115 and along an upper surface of the interface film pattern 120.

The second gate insulating layer pattern 134 may comprise a high-k material. Specifically, the second gate insulating layer pattern 134 may comprise a material selected from the group including HfO₂, ZrO₂, Ta₂O₅, TiO₂, SrTiO₃, BaTiO₃, and SrTiO₃. The second gate insulating layer pattern 134 may be formed to an appropriate thickness according to the type of a device to be formed. For example, when the second gate insulating layer pattern 134 comprises HfO₂, it may be formed to a thickness of, but not limited to, approximately 50 Å or less (approximately 5 to 50 Å).

The work function adjustment film pattern 142 of the second transistor TR2 may be formed on the second gate insulating layer pattern 134 as illustrated in FIG. 1. In some embodiments of the present inventive concepts, the work function adjustment film pattern 142 may be in contact with the second gate insulating layer pattern 134.

In some embodiments of the present inventive concepts, the work function adjustment film pattern 142 may comprise, for example, a metal nitride. Specifically, the work function adjusting film pattern 142 may comprise at least one of TiN and TaN. More specifically, the work function adjustment film pattern 142 may be, but is not limited to, a single layer of TiN or a double layer consisting of a TiN layer and a TaN layer formed on the TiN layer.

The second gate insulating layer pattern 134 and the work function adjustment film pattern 142 of the second transistor TR2 may extend upward along sidewalls of the interlayer insulating film 110. The second gate insulating layer pattern 134 and the work function adjustment film pattern 142 are formed as such because the semiconductor device 1 according to the embodiment of FIG. 1 is fabricated using a replacement metal gate (RMG) process.

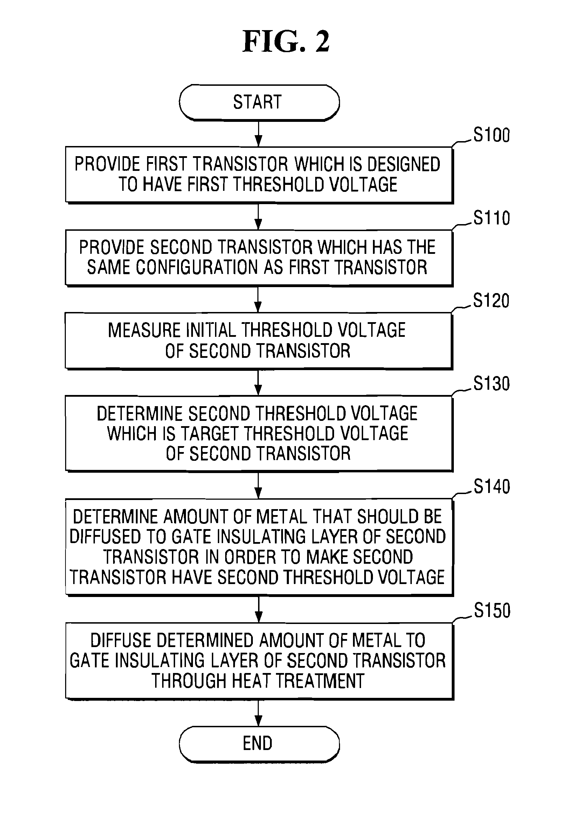

The gate metal pattern 162 may be formed on the work function adjustment film pattern 142 of the second transistor TR2. In some embodiments of the present inventive concepts, the gate metal pattern 162 may be formed in contact with the work function adjustment film pattern 142 as illustrated in FIG. 1. In some embodiments of the present inventive concepts, the gate metal pattern 162 may be made of, but not limited to, a conductive metal material such as Al or W.A method of fabricating the semiconductor device 1 of FIG. 1 according to an embodiment of the present inventive concepts will now be described with reference to FIGS. 2 through 5.

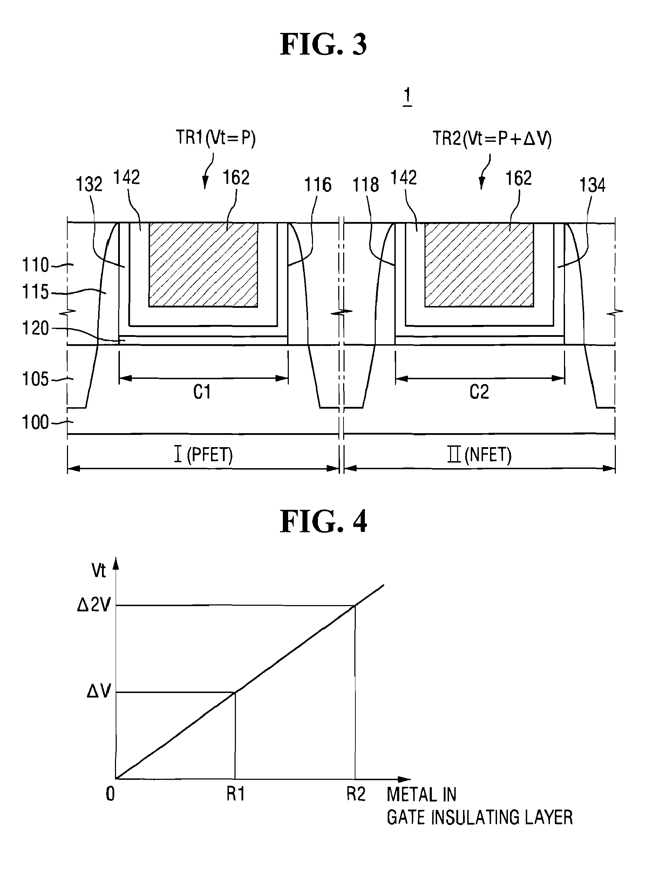

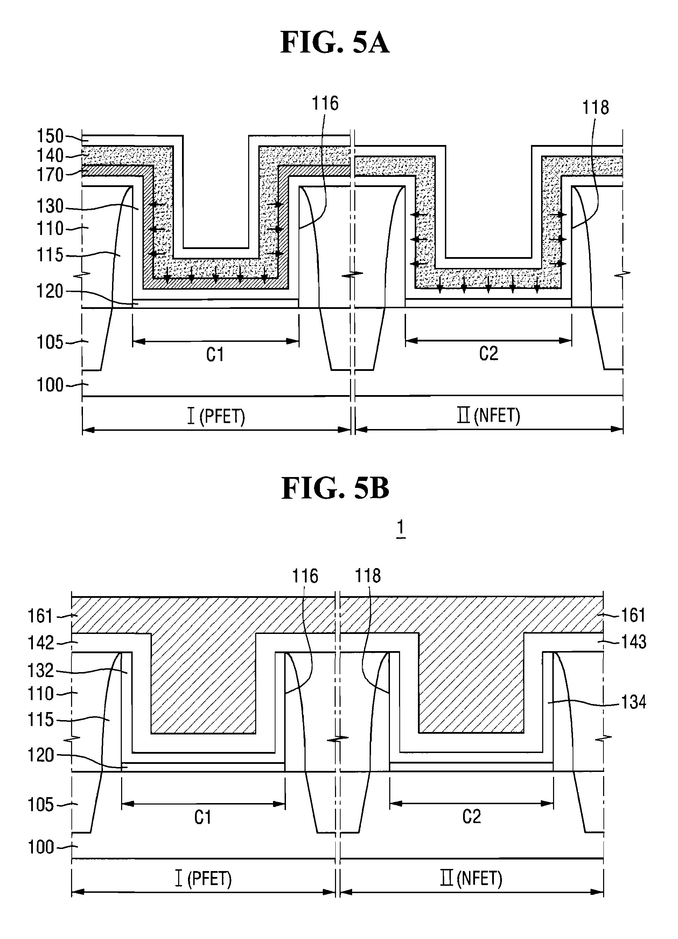

FIG. 2 is a flowchart illustrating a method of fabricating a semiconductor device according to an embodiment of the present inventive concepts. FIG. 3 is a cross-sectional view, FIG. 4 is a graph and FIGs. 5A and 5B are cross-sectional views illustrating a method of fabricating the semiconductor device of FIG. 1 according to an embodiment of the present inventive concepts.

Referring to FIG. 2, a first transistor designed to have a first threshold voltage is provided (operation S100). Specifically, referring to FIG. 3, a threshold voltage of a first transistor TR1 is adjusted to P by controlling parameters (for example, thickness, cross-sectional area, and material) of a first gate insulating layer pattern 132, a work function adjustment film pattern 142, and a gate metal pattern 162.

Referring to FIG. 2, a second transistor having the same configuration as the first transistor is provided (operation S110). Specifically, referring to FIG. 3, a second transistor TR2 having the same configuration as the first transistor TR1 described above is provided.

Referring to FIG. 2, an initial threshold voltage of the second transistor is measured (operation S120). Referring to FIG. 3, since a conductivity type of the second transistor TR2 is an N type and a conductivity type of the first transistor TR1 is a P type, the threshold voltage of the second transistor TR2 having the same configuration as the first transistor TR1 may be greater than the threshold voltage of the first transistor TR1 by, for example, ΔV. That is, the initial threshold voltage of the second transistor TR2 may be P + ΔV.

Referring to FIG. 2, a second threshold voltage which is a target threshold voltage of the second transistor is determined (operation S130). Referring to FIG. 1, in the embodiment of FIG. 1, since the first transistor TR1 and the second transistor TR2 should be adjusted to have the same threshold voltage, the second threshold voltage which is the target threshold voltage of the second transistor TR2 may be P.

Referring to FIG. 2, an amount of metal that should be diffused to a gate insulating layer of the second transistor to make the second transistor have the second threshold voltage is determined (operation S140).

A metal, for example, La or Al, may be diffused to a gate insulating layer of a transistor to change a threshold voltage of the transistor. For ease of description, it is assumed that the relationship between the concentration of a metal diffused to a gate insulating layer and a threshold voltage of a PFET is as illustrated in FIG. 4.

That is, when the concentration of the metal diffused to the gate insulating layer is a first concentration R1, the threshold voltage of the PFET may be changed by ΔV. When the concentration of the metal diffused to the gate insulating layer is a second concentration R2, the threshold voltage of the PFET may be changed by Δ2V. It is assumed that the same applies to an NFET but with opposite signs. That is, when the concentration of the metal diffused to the gate insulating layer is the first concentration R1, a threshold voltage of the NFET may be changed by -ΔV. When the concentration of the metal diffused to the gate insulating layer is the second concentration R2, the threshold voltage of the NFET may be changed by -Δ2V.

Referring to FIG. 3, since the initial threshold voltage of the second transistor TR2 is P + ΔV, a metal of the first concentration R1 (see FIG. 4) should be diffused to a second gate insulating layer pattern 134 of the second transistor TR2 in order to adjust the initial threshold voltage (P + ΔV) of the second transistor TR2 to P.

Referring to FIG. 2, the determined amount of metal is diffused to the gate insulating layer of the second transistor by heat treatment (operation S150). The determined amount of metal can be diffused to the gate insulating layer using various methods. One of the methods will now be described with reference to FIG. 5A.

Referring to FIG. 5A, an interlayer insulating film 110 including the first trench 116 which is formed on the first region I of the semiconductor substrate 100 and the second trench 118 which is formed on the second region II of the semiconductor substrate 100 is formed on the semiconductor substrate 100. As illustrated in FIG. 5A, a spacer 115 comprising at least one of a nitride film and an oxynitride film may be formed on both sidewalls of each of the first and second trenches 116 and 118.

An interface film pattern 120 is formed in each of the first and second trenches 116 and 118. The interface film pattern 120 may be formed by a thermal oxidation process. Then, a gate insulating layer 130 and a diffusion prevention film 170 are formed in the first and second trenches 116 and 118. The diffusion prevention film 170 formed in the second trench 118 is removed such that the diffusion prevention film 170 remains only in the first trench 116, as illustrated in FIG. 5A.

During a heat treatment process which will be described later, the diffusion prevention film 170 may prevent a metal contained in a metal-containing diffusion film 140 from diffusing to the gate insulating layer pattern 130 formed on the first region I of the semiconductor substrate 100. In some embodiments of the present inventive concepts, the diffusion prevention film 170 may comprise a metal nitride. An example of the metal nitride may be, but is not limited to, TiN.

The metal-containing diffusion film 140 and a protection film 150 are sequentially formed in the first and second trenches 116 and 118. As illustrated in FIG. 5A, the diffusion prevention film 170 exists under the metal-containing diffusion film 140 formed in the first trench 116 but does not exist under the metal-containing diffusion film 140 formed in the second trench 118.

The metal-containing diffusion film 140 may be a metal oxide film. Specifically, the metal-containing diffusion film 140 may be, but is not limited to, any one of La₂O₃ and Al₂O₃. In some other embodiments of the present inventive concepts, the metal-containing diffusion film 140 may also be any one of Y₂O₃, Lu₂O₃, and SrO.

The protection film 150 may contain, for example, a metal nitride. Specifically, in some embodiments of the present inventive concepts, the protection film 150 may contain at least one of TiN and TaN. More specifically, the protection film 150 may be, but is not limited to, a single layer of TiN or a double layer consisting of a TiN layer and a TaN layer formed on the TiN layer.

Then, the semiconductor substrate 100 is heat-treated. In the heat treatment process, the metal contained in the metal-containing diffusion film 140 is diffused to the gate insulating layer 130 disposed on the second region II of the semiconductor substrate 100 but is not to diffused the gate insulating layer 130 disposed on the first region I of the semiconductor substrate 100 due to the diffusion prevention film 170. That is, the metal may not exist in the gate insulating layer 130 of the first region I but may exist in the gate insulating layer 130 of the second region II.

Reffering to FIGs. 4 and 5A, the heat treatment process may be performed for a sufficient period of time such that the concentration of the metal diffused to the gate insulating layer 130 disposed on the second region II of the semiconductor substrate 100 becomes the first concentration R1.

During the heat treatment process, the protection film 150 may prevent the oxidation of the metal-containing diffusion film 140. Specifically, if the protection film 150 is not present, a top surface of the metal-containing diffusion film 140 may be exposed to the air during the heat treatment process and, thus, may be oxidized. In the embodiment of FIG. 5A, however, the protection film 150 is formed on the metal-containing diffusion film 140 to prevent the exposure of the metal-containing diffusion film 140 to the air. Therefore, the protection film 150 can prevent the oxidation of the metal-containing diffusion film 140 during the heat treatment process.

After the heat treatment process, the protection film 150 and the metal-containing diffusion film 140 formed in the first and second trenches 116 and 118 and the diffusion prevention film 170 formed in the first trench 116 are removed. Then, as illustrated in FIG. 5B, a work function adjustment film 143 is formed on the exposed gate insulating layer 130 in the first and second trenches 116 and 118. That is, the diffusion prevention film 170 formed in the first trench 116 is removed exposing the gate insulating layer 130.

Referring to FIG. 5B, a gate metal 161 is formed on the work function adjustment film 143 in the first and second trenches 116 and 118. Then, the gate metal 161, the work function adjustment film 143, and the gate insulating layer 130 are planarized until a top surface of the interlayer insulating film 110 is exposed. As a result, a semiconductor device 1 as shown in FIG. 1 can be fabricated.

The work function adjustment film pattern 142 included in both the first transistor TR1 and the second transistor TR2 is of a P-type has been described above as an example. However, the present inventive concepts are not limited thereto.

In some embodiments of the present inventive concepts, the work function adjustment film pattern 142 included in both the first transistor TR1 and the second transistor TR2 may also be of an N-type. If the work function adjustment film pattern 142 has the N-type, the first transistor (operation S100 in FIG. 2) designed to have the first threshold voltage may be the second transistor TR2 of FIG. 1. That is, the order of the N-type and the P-type in the above description may be reversed.

The N-type work function adjustment film pattern 142 may be, but is not limited to, a material selected from the group including TiAl, TiAIN, TaC, TiC, and HfSi.

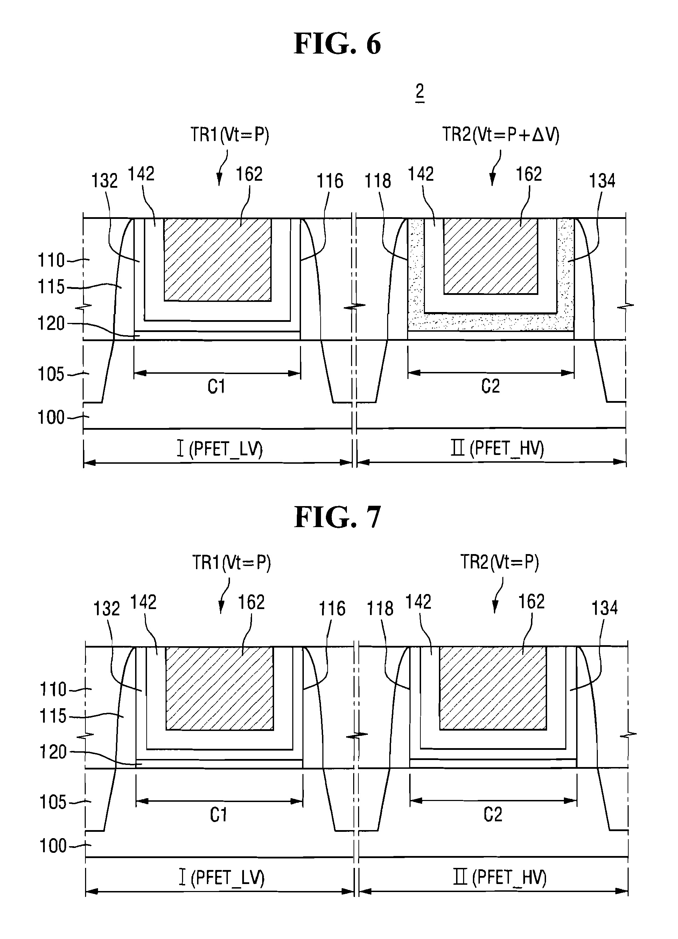

A semiconductor device according to another embodiment of the present inventive concepts will now be described with reference to FIG. 6.

FIG. 6 is a cross-sectional view of a semiconductor device 2 according to another embodiment of the present inventive concepts.

Referring to FIG. 6, the semiconductor device 2 includes a first transistor TR1 and a second transistor TR2. The configurations of the first transistor TR1 and the second transistor TR2 are identical to those of the previous embodiment described above in connection with FIG. 1, and, thus, a detailed description thereof will be omitted.

In the embodiment of FIG. 6, a first region I of a semiconductor substrate 100 may be a low-voltage region in which a low-voltage device is formed, and a second region II of the semiconductor substrate 100 may be a high-voltage region in which a high-voltage device is formed. In the embodiment of FIG. 6, the first transistor TR1 and the second transistor TR2 may have the same conductivity type. Specifically, both the first transistor TR1 and the second transistor TR2 may have, for example, a P-type.

In the embodiment of FIG. 6, the second transistor TR2 has the same conductivity type, for example, the P-type, as the first transistor TR1 and has the same configuration as the first transistor TR1. However, the second transistor TR2 may have a higher threshold voltage than the first transistor TR1. That is, if the threshold voltage of the first transistor TR1 is P as illustrated in FIG. 6, the threshold voltage of the second transistor TR2 may be P + ΔV. The second transistor TR2 having a higher threshold voltage than the first transistor TR1 even though the first transistor and the second transistor TR1 and TR2 have the same configuration may be due to a metal diffusing to a second gate insulating layer pattern 134 of the second transistor TR2.

A method of fabricating the semiconductor device 2 according to the embodiment of FIG. 6 will now be described with reference to FIGS. 2, 4, 6 and 7.

FIG. 7 is a cross-sectional view illustrating a method of fabricating a semiconductor device according to another embodiment of the present inventive concepts.

First, referring to FIG. 2, a first transistor designed to have a first threshold voltage is provided (operation S100). Specifically, referring to FIG. 7, a threshold voltage of a first transistor TR1 is adjusted to P by controlling parameters (for example, thickness, cross-sectional area, and material) of a first gate insulating layer pattern 132, a work function adjustment film pattern 142, and a gate metal pattern 162.

Referring to FIG. 2, a second transistor having the same configuration as the first transistor is provided (operation S110). Specifically, referring to FIG. 7, a second transistor TR2 having the same configuration as the first transistor TR1 described above is provided.

Referring to FIG. 2, an initial threshold voltage of the second transistor is measured (operation S120). Referring to FIG. 7, since the first transistor TR1 and the second transistor TR2 have the same conductivity type in the embodiment of FIG. 6, they may have the same threshold voltage P. Therefore, an initial threshold voltage of the second transistor TR2 may be P.

Referring to FIG. 2, a second threshold voltage which is a target threshold voltage of the second transistor is determined (operation S130). Referring to FIG. 6, in the embodiment of FIG. 6, since the second transistor TR2, unlike the first transistor TR1, is a high-voltage transistor formed in a high-voltage region, the threshold voltage of the second transistor TR2 should be higher than that of the first transistor TR1. Therefore, the second threshold voltage, which is the target threshold voltage of the second transistor TR2, may be P + ΔV.

Referring to FIG. 2, an amount of metal that should be diffused to a gate insulating layer of the second transistor to make the second transistor have the second threshold voltage is determined (operation S140).

As described above, a metal may be diffused to a gate insulating layer of a transistor to change a threshold voltage of the transistor. In addition, it is assumed that the relationship between the concentration of a metal diffused to a gate insulating layer and a threshold voltage of a PFET is as shown in FIG. 4.

Referring to FIG. 4, to increase the threshold voltage of the second transistor TR2 (i.e., a PFET) by ΔV, the concentration of the metal diffused to the gate insulating layer should be a first concentration R1.

Referring to FIG. 2, the determined amount of metal is diffused to the gate insulating layer of the second transistor by heat treatment (operation S150). An example method of diffusing the determined amount of metal to the gate insulating layer has been fully described above in connection with FIGs. 5A and 5B, and, thus, a detailed description thereof is omitted.

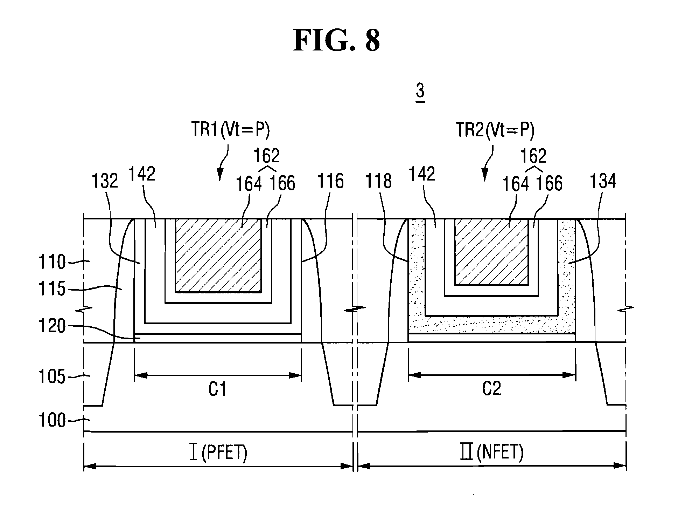

A semiconductor device according to another embodiment of the present inventive concepts will now be described with reference to FIG. 8.

FIG. 8 is a cross-sectional view of a semiconductor device 3 according to another embodiment of the present inventive concepts. The following description will focus on differences from the previous described embodiments.

Referring to FIG. 8, the semiconductor device 3 includes a first transistor TR1 formed on a first region I of a semiconductor substrate 100 and a second transistor TR2 formed on a second region II of the semiconductor substrate 100.

In the embodiment of FIG.. 8, a gate metal pattern 162 of each of the first and second transistors TR1 and TR2 may include a conductive pattern 164 and a barrier pattern 166. In particular, in the embodiment of FIG. 8, the conductive pattern 164 may be an Al gate electrode which contains Al, and the barrier pattern 166 may prevent Al contained in the conductive pattern 164 from entering a channel region C1 or C2 of the first or second transistor TR1 or TR2 or a first or second gate insulating layer pattern 132 or 134.

The first transistor TR1 is designed to have a threshold voltage of P, and an initial threshold voltage of the second transistor TR2 having the same configuration as the first transistor TR1 is measured. That is, the initial threshold voltage of the second transistor TR2 may be higher than P. Then, the threshold voltage of the second transistor TR2 is adjusted to P by diffusing a metal to the second gate insulating layer pattern 134 of the second transistor TR2. Since this has been fully described above in connection with FIGs. 1-5B, a description thereof is omitted.

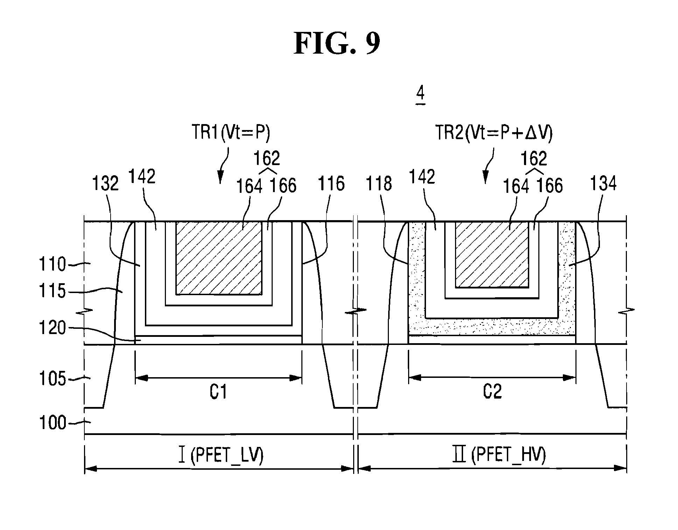

A semiconductor device according to another embodiment of the present inventive concepts will now be described with reference to FIG. 9.

FIG. 9 is a cross-sectional view of a semiconductor device 4 according to another embodiment of the present inventive concepts. The following description will focus on differences from the previous described embodiments.

Referring to FIG. 9, the semiconductor device 4 includes a first transistor TR1 formed on a first region I of a semiconductor substrate 100 and a second transistor TR2 formed on a second region II of the semiconductor substrate 100.

The first region I of the semiconductor substrate 100 may be a low-voltage region in which a low-voltage device is formed, and the second region II of the semiconductor substrate 100 may be a high-voltage region in which a high-voltage device is formed. In the embodiment of FIG. 9, the first transistor TR1 and the second transistor TR2 may have the same conductivity type. Specifically, both the first transistor TR1 and the second transistor TR2 may have, for example, a P-type.

In the embodiment of FIG. 9, a gate metal pattern 162 of each of the first and second transistors TR1 and TR2 may include a conductive pattern 164 and a barrier pattern 166. In particular, in the embodiment of FIG. 9, the conductive pattern 164 may be an Al gate electrode which contains Al, and the barrier pattern 166 may prevent Al contained in the conductive pattern 164 from entering a channel region C1 or C2 of the first or second transistor TR1 or TR2 or a first or second gate insulating layer pattern 132 or 134.

The first transistor TR1 is designed to have a threshold voltage of P, and an initial threshold voltage of the second transistor TR2 having the same configuration as the first transistor TR1 is measured. The initial threshold voltage of the second transistor TR2 may be P. Then, the threshold voltage of the second transistor TR2 is adjusted to P + ΔV by diffusing a metal to the second gate insulating layer pattern 134 of the second transistor TR2. Since this has been fully described above in connection with FIGs. 6 and 7, a description thereof is omitted.

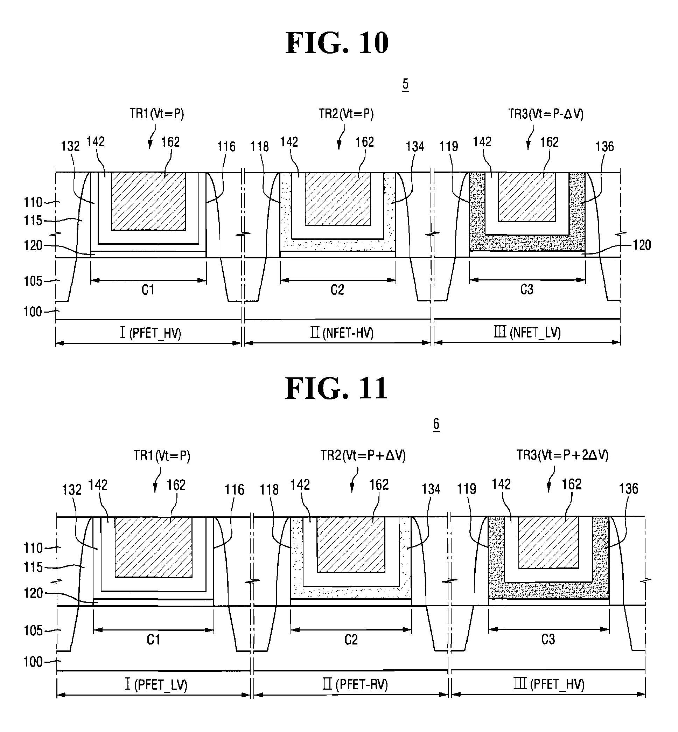

A semiconductor device according to another embodiment of the present inventive concepts will now be described with reference to FIG. 10.

FIG. 10 is a cross-sectional view of a semiconductor device 5 according to another embodiment of the present inventive concepts.

Referring to FIG. 10, the semiconductor device 5 includes first, second and third transistors TR1 through TR3.

The first transistor TR1 may be formed on a first region I of a semiconductor substrate 100, the second transistor TR2 may be formed on a second region II of the semiconductor substrate 100, and the third transistor TR3 may be formed on a third region III of the semiconductor substrate 100.

In the embodiment of FIG. 10, the first region I may be a region in which a P-type high-voltage transistor is formed, the second region II may be a region in which an N-type high-voltage transistor is formed, and the third region III may be a region in which an N-type low-voltage transistor is formed. That is, in the embodiment of FIG. 10, the first transistor TR1 may be a high-voltage PFET, the second transistor TR2 may be a high-voltage NFET, and the third transistor TR3 may be a low-voltage NFET.

Detailed configurations of the first, and second transistors TR1 and TR2 may be identical to the previous embodiments described above, and, thus, a detailed description thereof will be omitted.

The third transistor TR3 may include an interface film pattern 120, a third gate insulating layer pattern 136, a work function adjustment film pattern 142, and a gate metal pattern 162 formed sequentially in a third trench 119 on a third channel region C3 which is defined in the third region III of the semiconductor substrate 100. A device isolation film 105, such as a shallow trench isolation (STI) film, may be formed in the semiconductor substrate 100 to define the third channel region C3. A spacer 115 may be formed on both sidewalls of the first trench 116 as illustrated in FIG. 10. The spacer 115 may include at least one of a nitride film and an oxynitride film. Although not illustrated in FIG. 10, the spacer 115 may be L-shaped.

In the embodiment of FIG. 10, the concentration of a metal contained in the first gate insulating layer pattern 132 of the first transistor TR1, the concentration of a metal contained in the second gate insulating layer pattern 134 of the second transistor TR2, and the concentration of a metal contained in the third gate insulating layer pattern 136 of the third transistor TR3 may be different from each other.

Specifically, as shown in FIG. 10, no metal may exist in the first gate insulating layer pattern 132 of the first transistor TR1, and the concentration of the metal contained in the third gate insulating layer pattern 136 of the third transistor TR3 may be greater than the concentration of the metal contained in the second gate insulating layer pattern 134 of the second transistor TR2. Therefore, the third gate insulating layer pattern 136 of the third transistor TR3 may be thicker than the second gate insulating layer pattern 134 of the second transistor TR2, and the second gate insulating layer pattern 134 of the second transistor TR2 may be thicker than the first gate insulating layer pattern 132 of the first transistor TR1.

According to the above concentration distribution of the metal, when a threshold voltage of the first transistor TR1 is P, a threshold voltage of the second transistor TR2 may also be P, and a threshold voltage of the third transistor TR3 may be P - ΔV which is lower than the threshold voltages of the first and second transistors TR1 and TR2.

Specifically, the first transistor TR1 is configured to have a threshold voltage of P. Thus, the threshold voltage of the first transistor TR1 may be P. Since conductivity types of the second and third transistors TR2 and TR3 are an N-type, if the second and third transistors TR2 and TR3 have the same configuration as the first transistor TR1, their initial threshold voltages may be higher than P. It is assumed here that the initial threshold voltages of the second and third transistors TR2 and TR3 are, for example, P + ΔV, as described in connection with FIGs. 1-5.

Like the first transistor TR1, the second transistor TR2 is a transistor formed in a high-voltage region, for example, the second region II. Thus, the threshold voltage of the second transistor TR2 should be the same as that of the first transistor TR1. Accordingly, a target threshold voltage of the second transistor TR2 is P.

Since the third transistor TR3 is a transistor formed in a low-voltage region, for example, the third region III, the threshold voltage of the third transistor TR3 should be lower than the threshold voltage of the first and second transistors TR1 and TR2. Therefore, a target threshold voltage of the third transistor TR3 is P - ΔV.

Referring to FIG. 4, to lower the threshold voltage of the second transistor TR2 by ΔV, a metal of a first concentration R1 should be diffused to a gate insulating layer. Since the second transistor TR2 is an NFET, a greater concentration of metal reduces the threshold voltage. To lower the threshold voltage of the third transistor TR3 by Δ2V, a metal of a second concentration R2 should be diffused to the gate insulating layer.

Therefore, if no metal exists in the first gate insulating layer pattern 132 of the first transistor TR1 and, if the concentration of a metal contained in the third gate insulating layer pattern 136 of the third transistor TR3 is greater than the concentration of the metal contained in the second gate insulating layer pattern 134 of the second transistor TR2, as illustrated in FIG. 10, when the threshold voltage of the first transistor TR1 is P, the threshold voltage of the second transistor TR2 may also be P, and the threshold voltage of the third transistor TR3 may be P - ΔV which is lower than the threshold voltages of the first and second transistors TR1 and TR2. An example method of fabricating the first, second and third transistors TR1, TR2 and TR3 will be described hereinafter.

A semiconductor device according to another embodiment of the present inventive concepts will now be described with reference to FIG. 11.

FIG. 11 is a cross-sectional view of a semiconductor device 6 according to another embodiment of the present inventive concepts. The following description will focus on differences from the previous described embodiments.

Referring to FIG. 11, the semiconductor device 6 includes first, second and third transistors TR1, TR2 and TR3.

The first transistor TR1 may be formed on a first region I of a semiconductor substrate 100, the second transistor TR2 may be formed on a second region II of the semiconductor substrate 100, and the third transistor TR3 may be formed on a third region III of the semiconductor substrate 100.

In the embodiment of FIG. 11, the first region I may be a region in which a P-type low-voltage transistor is formed, the second region II may be a region in which a P-type regular-voltage transistor is formed, and the third region III may be a region in which a P-type high-voltage transistor is formed. That is, in the embodiment of FIG. 11, the first transistor TR1 may be a low-voltage PFET, the second transistor TR2 may be a regular-voltage PFET, and the third transistor TR3 may be a high-voltage PFET.

In the embodiment of FIG. 11, as illustrated in FIG. 11, no metal may exist in a first gate insulating layer pattern 132 of the first transistor TR1, and the concentration of a metal contained in a third gate insulating layer pattern 136 of the third transistor TR3 may be greater than the concentration of a metal oxide contained in a second gate insulating layer pattern 134 of the second transistor TR2.

Therefore, the third gate insulating layer pattern 136 of the third transistor TR3 may be thicker than the second gate insulating layer pattern 134 of the second transistor TR2, and the second gate insulating layer pattern 134 of the second transistor TR2 may be thicker than the first gate insulating layer pattern 132 of the first transistor TR1.

The first transistor TR1 is designed to have a threshold voltage of P, and an initial threshold voltage of the second and third transistors TR2 and TR3 having the same configuration as the first transistor TR1 are measured. The initial threshold voltage of the second transistor TR2 may be P and the initial threshold voltage of the third transistor TR3 may be P. Then, the threshold voltage of the second transistor TR2 is adjusted to P + ΔV by diffusing a metal to the second gate insulating layer pattern 134 of the second transistor TR2, and the threshold voltage of the third transistor TR3 is adjusted to P + 2ΔV by diffusing a metal to the third gate insulating layer pattern 136 of the third transistor TR3. Since this has been fully described above in connection with FIG. 9, a description thereof is omitted.

According to the above concentration distribution of the metal, when a threshold voltage of the first transistor TR1 is P, a threshold voltage of the second transistor TR2 may be P + ΔV, and a threshold voltage of the third transistor TR3 may be P + Δ2V. The method for making the first, second and third transistors TR1, TR2 and TR3 have the above threshold voltages can be easily induced from the above-described embodiments of the present inventive concepts, and thus a detailed description is omitted.

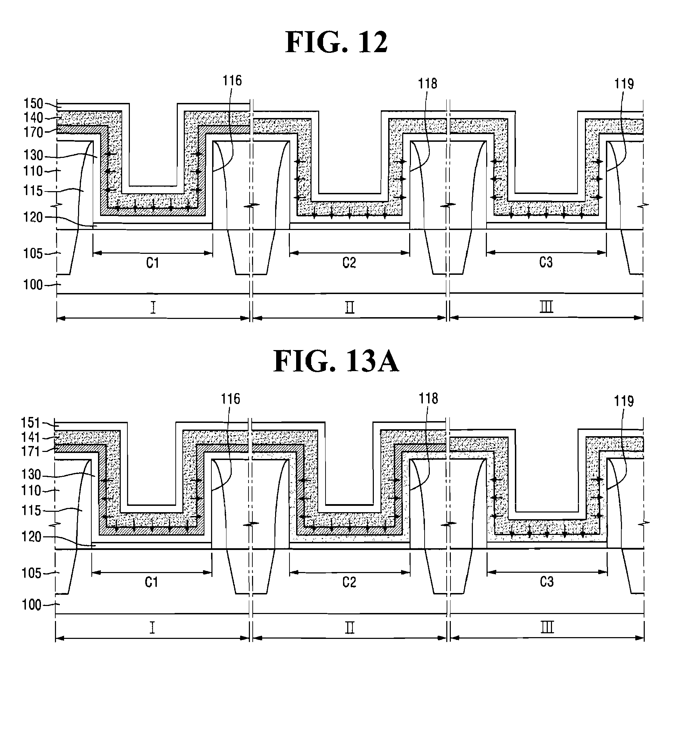

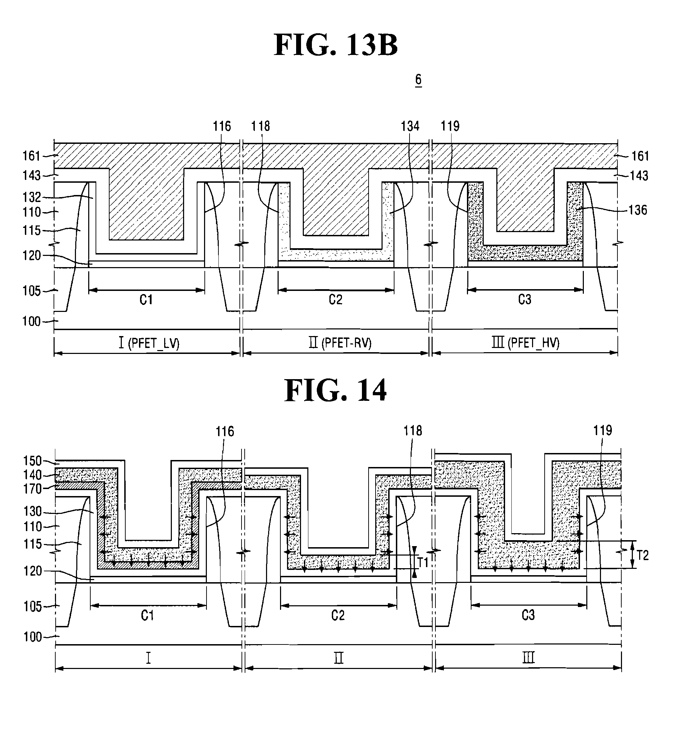

An exemplary method of fabricating the above semiconductor devices 5 and 6 will now be described with reference to FIGS. 12, 13A and 13B.

FIGS. 12, 13A and 13B are views illustrating a method of fabricating a semiconductor device according to another embodiment of the present inventive concepts.

Referring to FIG. 12, an interlayer insulating film 110 including a first trench 116 formed on a first region I of a semiconductor substrate 100, a second trench 118 formed on a second region II of the semiconductor substrate 100, and a third trench 119 formed on a third region III of the semiconductor substrate 100 is formed on the semiconductor substrate 100. Here, a spacer 115 made of at least one of a nitride film and an oxynitride film may be formed on both sidewalls of each of the first, second and third trenches 116, 118 and 119.

An interface film pattern 120 is formed in each of the first, second and third trenches 116, 118 and 119. Here, the interface film pattern 120 may be formed by a thermal oxidation process. Then, a gate insulating layer 130 and a first diffusion prevention film 170 are sequentially formed in the first, second and third trenches 116, 118 and 119. The first diffusion prevention film 170 formed in the second and third trenches 118 and 119 is removed such that the first diffusion prevention film 170 remains only in the first trench 116.

A diffusion film 140 which contains a metal oxide and a protection film 150 are sequentially formed in the first, second and third trenches 116, 118 and 119. As a result, the first diffusion prevention film 170 exists under the diffusion film 140 formed in the first trench 116, but does not exist under the diffusion film 140 formed in the second and third trenches 118 and 119.

A first heat treatment process is performed on the semiconductor substrate 100. In the first heat treatment process, the metal contained in the diffusion film 140 is diffused to the gate insulating layer 130 disposed on the second and third regions II and III of the semiconductor substrate 100 but not to the gate insulating layer 130 disposed on the first region I of the semiconductor substrate 100 due to the first diffusion prevention film 170.

That is, the metal may not exist in the gate insulating layer 130 of the first region I but may exist in the gate insulating layer 130 of the second and third regions II and III. The first heat treatment process may be performed for a sufficient period of time such that the concentration of the metal diffused to the gate insulating layer 130 disposed on the second and third regions II and III of the semiconductor substrate 100 becomes a first concentration R1 (see FIG. 4).

After the first heat treatment process, the protection film 150 and the diffusion film 140 formed in the first, second and third trenches 116, 118 and 119 and the first diffusion prevention film 170 formed in the first trench 116 are removed, thereby exposing the gate insulating layer 130 in the first, second and third trenches 116, 118 and 119.

Referring to FIG. 13A, a second diffusion prevention film 171 is formed on the exposed gate insulating layer 130 in the first, second and third trenches 116, 118 and 119. Then, the second diffusion prevention film 171 formed in the third trench 119 is removed such that the second diffusion prevention film 171 remains only in the first and second trenches 116 and 118.

A second diffusion film 141 which contains a metal oxide and a second protection film 151 are sequentially formed in the first, second and third trenches 116, 118 and 119. As a result, the second diffusion prevention film 171 exists under the second diffusion film 141 formed in the first and second trenches 116 and 118 but does not exist under the second diffusion film 141 formed in the third trench 119.

Next, a second heat treatment process is performed on the semiconductor substrate 100. In the second heat treatment process, the metal contained in the second diffusion film 141 is diffused to the gate insulating layer 130 disposed on the third region III of the semiconductor substrate 100 but not to the gate insulating layer 130 disposed on the first and second regions I and II of the semiconductor substrate 100 due to the second diffusion prevention film 171. The second heat treatment process may be performed for a sufficient period of time such that the concentration of the metal diffused to the gate insulating layer 130 disposed on the third region III of the semiconductor substrate 100 becomes a second concentration R2 (see FIG. 4).

After the second heat treatment process, the second protection film 151 and the second diffusion film 141 formed in the first, second and third trenches 116, 118 and 119 and the second diffusion prevention film 171 formed in the first and second trenches 116 and 118 are removed. Then, a work function adjustment film 143, as illustrated in FIG. 13B, is formed on the exposed gate insulating layer 130 in the first, second and third trenches 116, 118 and 119. That is, the second diffusion prevention film 171 formed in the first and second trenches 116 and 118 is removed exposing the gate insulating layer 130.

Referring to FIG. 13B, a gate metal 161 is formed on the work function adjustment film 143 in the first, second and third trenches 116, 118 and 119. Then, the gate metal 161, the work function adjustment film 143, and the gate insulating layer 130 are planarized until a top surface of the interlayer insulating film 110 is exposed (see FIGs. 10 and 11). As a result, a semiconductor device 5 or 6 as shown in FIG. 10 or 11 may be fabricated.

Another exemplary method of fabricating the above-described semiconductor devices 5 and 6 will now be described with reference to FIG. 14.

FIG. 14 is a cross-sectional view illustrating a method of fabricating a semiconductor device according to another embodiment of the present inventive concepts. Referring to FIG. 14, in the embodiment of FIG. 14, a diffusion film 140 is formed such that a thickness T1 of the diffusion film 140 formed in a second trench 118 is different from a thickness T2 of the diffusion film 140 formed in a third trench 119, prior to a first heat treatment process being performed. Specifically, the thickness T2 of the diffusion film 140 formed in the third trench 119 is greater than the thickness T1 of the diffusion film 140 formed in the second trench 118.

If the first heat treatment process is performed after the diffusion film 140 is formed thicker in the third trench 119 than in the second trench 118, an amount of metal diffused to a gate insulating layer 130 of the third region III may be greater than an amount of metal diffused to the gate insulating layer 130 of the second region II.

That is, through a single heat treatment process, a metal of a second concentration R2 (see FIG. 4) may be diffused to the gate insulating layer 130 of the third region III, and a metal of a first concentration R1 (see FIG. 4) may be diffused to the gate insulating layer 130 of the second region II. In this embodiment of FIG. 14, the second heat treatment process of the previous embodiment of FIGs. 13A is unnecessary. Accordingly, this can reduce the number of processes performed and the fabrication time in the fabrication of the semiconductor device.

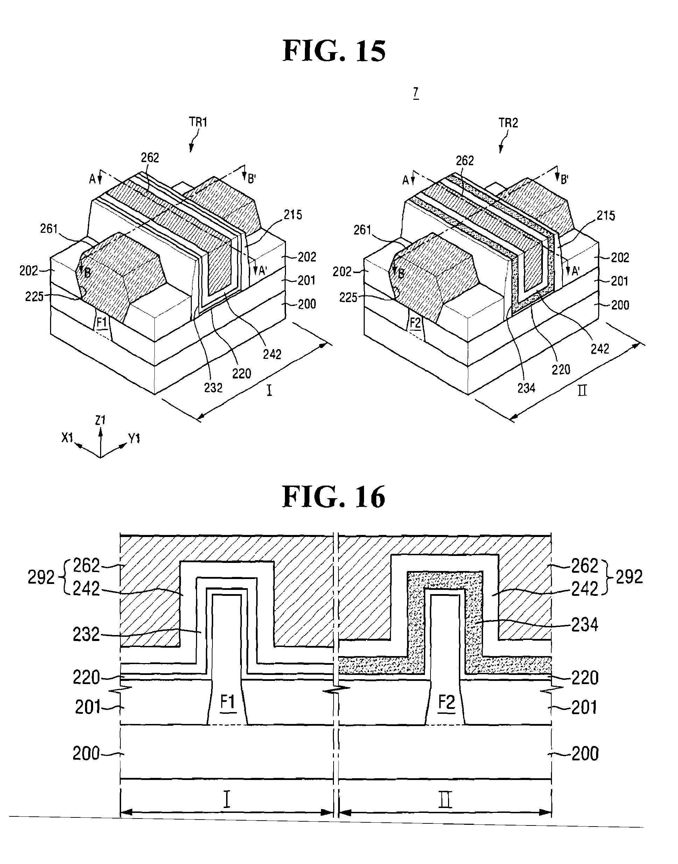

A semiconductor device according to another embodiment of the present inventive concepts will now be described with reference to FIGS. 15 through 17.

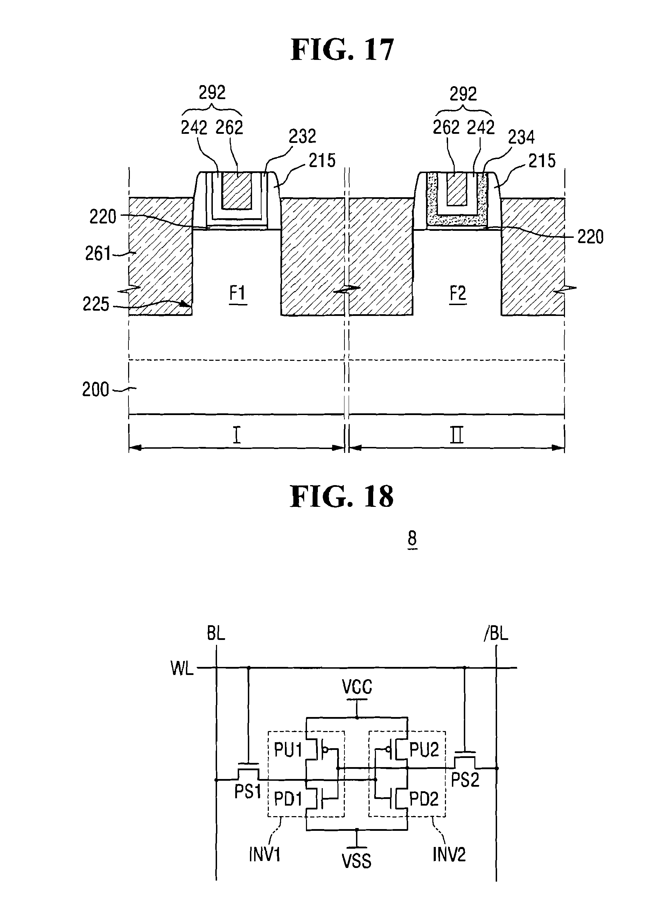

FIG. 15 is a perspective view of a semiconductor device 7 according to another embodiment of the present inventive concepts. FIG. 16 is a cross-sectional view taken along the line A-A' of FIG. 15. FIG. 17 is a cross-sectional view taken along the line B-B' of FIG. 15.

In FIGS. 15 through 17, the semiconductor device 1 of FIG. 1 is applied to a fin field effect transistor (FinFET). However, the present inventive concepts are not limited thereto. When necessary, the semiconductor devices 2 through 6 not shown in FIGS. 15 through 17 can also be applied to the FinFET.

Referring to FIGS. 15 through 17, the semiconductor device 7 may include fins F1 and F2, a gate electrode 292, a recess 225, and a source/drain 261.

The fins F1 and F2 may include a first fin F1 formed in a first region I of a semiconductor substrate 200 and a second fin F2 formed in a second region II of the semiconductor substrate 200. The first and second fins F1 and F2 may extend along a second direction Y1. Each of the first and second fins F1 and F2 may be part of the substrate 200 or may include an epitaxial layer grown from the substrate 200. A device isolation film 201 may cover side surfaces of the first and second fins F1 and F2.

A first transistor TR1 may be formed on the first fin F1, and a second transistor TR2 may be formed on the second fin F2. The first transistor TR1 may include an interface film pattern 220, a first gate insulating layer pattern 232, a work function adjustment film pattern 242, and a gate metal pattern 262 sequentially formed on the first fin F1.

The second transistor TR2 may include an interface film pattern 220, a second gate insulating layer pattern 234, a work function adjusting film pattern 242, and a gate metal pattern 262 sequentially formed on the second fin F2.

In the embodiment of FIGs. 15-17, the concentration of a metal contained in the first gate insulating layer pattern 232 may be different from that of the metal contained in the second gate insulating layer pattern 234. Specifically, the metal may not exist in the first gate insulating layer pattern 232 and may exist in the second gate insulating layer pattern 234. According to this concentration distribution of the metal, the first transistor TR1 and the second transistor TR2 may have the same threshold voltage although they have different conductivity types.

However, the present inventive concepts are not limited thereto. According to the concentration distribution of the metal, the first transistor TR1 and the second transistor TR2 can have the same conductivity type (e.g., a P type), and the threshold voltage of the second transistor TR2 can be adjusted to be higher than the threshold voltage of the first transistor TR1 as described above.

The gate electrode 292 may be formed on each of the first and second fins F1 and F2 to intersect each of the first and second fins F1 and F2. The gate electrode 292 may extend in a first direction X1. As illustrated in FIGs. 15-17, the gate electrode 292 may include the work function adjustment film pattern 242 and the gate metal pattern 262.

The recess 225 may be formed on each of the first and second fins F1 and F2 on both sides of the gate electrode 292. The recess 225 has sloping sidewalls. Thus, the recess 225 may become wider as the distance from the substrate 200 increases. As shown in FIG. 15, the recess 225 may be wider than the first and second fins F1 and F2.

The source/drain 261 is formed in the recess 225. The source/drain 261 may be an elevated source/drain. That is, a top surface of the source/drain 261 may be higher than a bottom surface of an interlayer insulating film 202. In addition, the source/drain 261 and the gate electrode 292 may be insulated from each other by a spacer 215.

When the first transistor TR1 is a P-type transistor, the source/drain 261 may include a compressive stress material. The compressive stress material may be a material (e.g., SiGe) having a greater lattice constant than Si. The compressive stress material may apply compressive stress to the first fin F1, thereby improving the mobility of carriers in a channel region.

When the second transistor TR2 is an N-type transistor, the source/drain 261 may be the same material as the substrate 200 or a tensile stress material. For example, when the substrate 200 is Si, the source/drain 261 may be Si or a material (e.g., SiC) having a smaller lattice constant than Si.

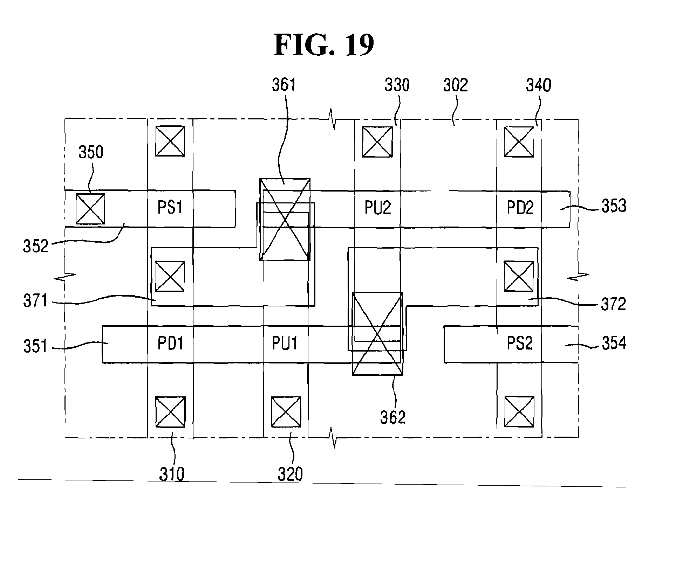

A semiconductor device according to another embodiment of the present inventive concepts will now be described with reference to FIGS. 18 and 19.

FIGS. 18 and 19 are respectively circuit and layout diagrams of a semiconductor device 8 according to another embodiment of the present inventive concepts.

Referring to FIGS. 18 and 19, the semiconductor device 8 may include a pair of inverters INV1 and INV2 connected in parallel between a power supply node Vcc and a ground node Vss and first and second pass transistors PS1 and PS2 connected to output nodes of the inverters INV1 and INV2, respectively. The first pass transistor PS1 and the second pass transistor PS2 may be connected to a bit line BL and a complementary bit line BL/, respectively. A gate of the first pass transistor PS1 and a gate of the second pass transistor PS2 may be connected to a word line WL.

The first inverter INV1 includes a first pull-up transistor PU1 and a first pull-down transistor PD1 connected in series to each other, and the second inverter INV2 includes a second pull-up transistor PU2 and a second pull-down transistor PD2 connected in series to each other. The first pull-up transistor PU1 and the second pull-up transistor PU2 may be PFETs, and the first pull-down transistor PD1 and the second pull-down transistor PD2 may be NFETs.

In addition, an input node of the first inverter INV1 is connected to the output node of the second inverter INV2, and an input node of the second inverter INV2 is connected to the output node of the first inverter INV1, so that the first inverter INV1 and the second inverter INV2 form one latch circuit.

Referring to FIGS. 18 and 19, first, second, third and fourth active regions 310, 320, 330 and 340 are separated from each other and extend in a direction, for example, a vertical direction in FIG. 19. The second active region 320 and the third active region 330 may be shorter than the first active region 310 and the fourth active region 340.

In addition, first, second, third and fourth gate electrodes 351, 352, 353 and 354 extend in the other direction, for exmaple, a horizontal direction in FIG. 19, and intersect the first, second, third and fourth active regions 310, 320, 330 and 340. Specifically, the first gate electrode 351 may completely intersect the first active region 310 and the second active region 320 and may overlap an end of the third active region 330. The third gate electrode 353 may completely intersect the fourth active region 340 and the third active region 330 and may overlap an end of the second active region 320. The second gate electrode 352 may intersect the first active region 310 and the fourth gate electrode 354 may intersect the fourth active region 340.

As illustrated in FIGs. 18 and 19, the first pull-up transistor PU1 is defined around a region in which the first gate electrode 351 intersects the second active region 320, the first pull-down transistor PD1 is defined around a region in which the first gate electrode 351 intersects the first active region 310, and the first pass transistor PS1 is defined around a region in which the second gate electrode 352 intersects the first active region 310. The second pull-up transistor PU2 is defined around a region in which the third gate electrode 353 intersects the third active region 330, the second pull-down transistor PD2 is defined around a region in which the third gate electrode 353 intersects the fourth active region 340, and the second pass transistor PS2 is defined around a region in which the fourth gate electrode 354 intersects the fourth active region 340.

Although not shown clearly, a recess may be formed on both sides of each of the regions in which the first, second, third and fourth gate electrodes 351, 352, 353 and 354 intersect the first, second, third and fourth active regions 310, 320, 330 and 340, and a source/drain may be formed in the recess. Also, a plurality of contacts 350 may be formed.

Furthermore, a first shared contact 361 connects all of the second active region 320, a third gate electrode 353, and a first wiring 371. A second shared contact 362 connects all of the third active region 330, the first gate electrode 351, and a second wiring 372.

The first pull-up transistor PU1 and the second pull-up transistor PU2 may be configured in the same way as any one of the P-type transistors according to the above-described embodiments of the present inventive concepts, and the first pull-down transistor PD1, the first pass transistor PS1, the second pull-down transistor PD2, and the second pass transistor PS2 may be configured in the same way as any one of the N-type transistors according to the above-described embodiments of the present inventive concepts.

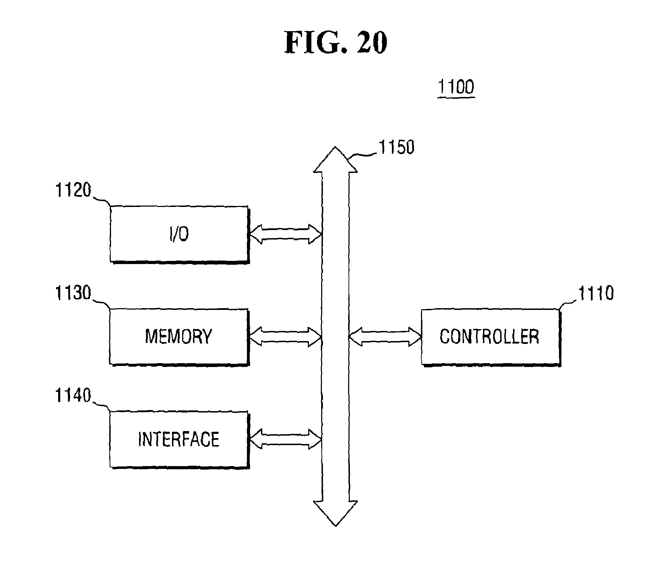

FIG. 20 is a block diagram of an electronic system 1100 including semiconductor devices according to some embodiments of the present inventive concepts.

Referring to FIG. 20, the electronic system 1100 according to an embodiment of the present inventive concepts may include a controller 1110, an input/output (I/O) device 1120, a memory device 1130, an interface 1140, and a bus 1150. The controller 1110, the I/O device 1120, the memory device 1130, and/or the interface 1140 may be coupled to each other through the bus 1150. The bus 1150 corresponds to a path through which data is transferred.

The controller 1110 may include at least one of a microprocessor, a digital signal processor, a microcontroller, and logic devices capable of performing similar functions to those of the above elements. The I/O device 1120 may include a keypad, a keyboard, and/or a display device. The memory device 1130 may store data and/or commands. The interface 1140 may transmit data to a communication network or receive data from the communication network. The interface 1140 can be in a wired or wireless form. For example, the interface 1140 may be an antenna or a wire/wireless transceiver. Although not illustrated in the drawing, the electronic system 1100 may further include a high-speed DRAM and/or a high-speed SRAM as an operation memory for improving the operation of the controller 1110.

The semiconductor devices 1 through 8 according to the above embodiments of the present inventive concepts may be provided within the memory device 1130 or provided as a part of the controller 1110 or the I/O device 1120.

The electronic system 1100 can be applied to a personal digital assistant (PDA), a portable computer, a web tablet, a wireless phone, a mobile phone, a digital music player, a memory card, and all electronic products that can transmit and/or receive information in a wireless environment.

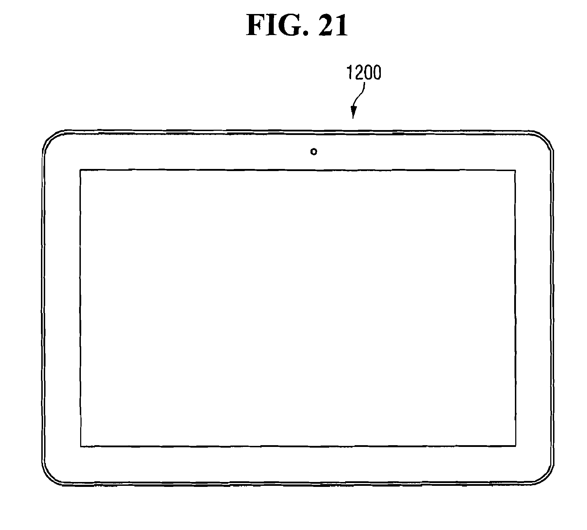

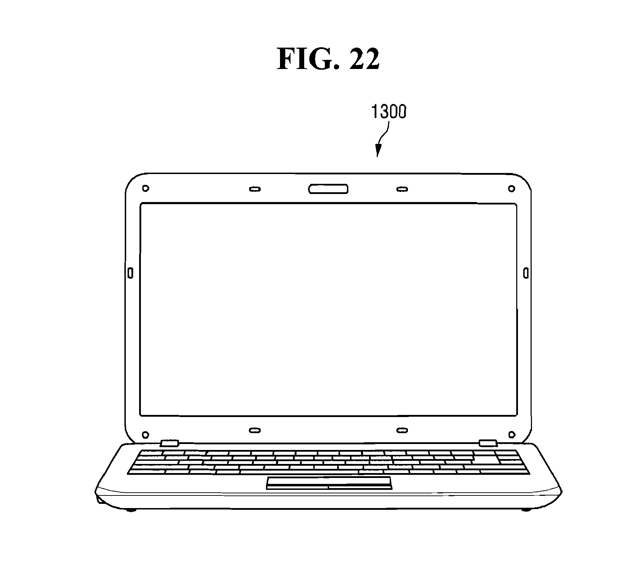

FIGS. 21 and 22 are example semiconductor systems to which semiconductor devices according to some embodiments of the present inventive concepts can be applied. FIG. 21 shows a tablet PC 1200, and FIG. 22 shows a notebook computer 1300. At least one of the semiconductor devices 1 through 8 according to the above-described embodiments of the present inventive concepts can be used in a table PC, a notebook computer, and the like. It is obvious to those of ordinary skill in the art that the semiconductor devices according to the embodiments of the present inventive concepts are also applicable to other integrated circuit devices not shown in the drawings.

While the inventive concepts have been particularly shown and described with reference to example embodiments thereof, it will be understood that various changes in form and details may be made therein without departing from the spirit and scope of the following claims.

## Claims

1. A semiconductor device comprising:
a semiconductor substrate comprising a first region and a second region;
a first transistor on the first region; and
a second transistor on the second region,
wherein the first transistor comprises a first gate insulating layer pattern, the second transistor comprises a second gate insulating layer pattern, the first and second transistors both comprise a work function adjustment film pattern and a gate metal pattern, wherein the work function adjustment film pattern of the first transistor comprises the same material as the work function adjustment film pattern of the second transistor and the gate metal pattern of the first transistor comprises the same material as gate metal pattern of the second transistor, and a concentration of a metal contained in the first gate insulating layer pattern to adjust a threshold voltage of the first transistor is different from a concentration of the metal contained in the second gate insulating layer pattern to adjust a threshold voltage of the second transistor.

2. The semiconductor device of claim 1, wherein the metal comprises La or Al.

3. The semiconductor device of claim 1 or 2, wherein the metal does not exist in the first gate insulating layer pattern and exists in the second gate insulating layer pattern.

4. The semiconductor device of any one of claims 1 to 3, wherein the work function adjustment film patterns of the first and second transistors comprise a metal nitride, preferably TiN.

5. The semiconductor device of any one of claims 1 to 4, wherein the work function adjustment film pattern of the first transistor contacts the first gate insulating layer pattern and the gate metal pattern of the first transistor and the work function adjustment film pattern of the second transistor contacts the second gate insulating layer pattern and the gate metal pattern of the second transistor.

6. The semiconductor device of any one of claims 1 to 5, wherein the first transistor and the second transistor have different conductivity types.

7. The semiconductor device of claim 6, wherein the first transistor and the second transistor have the same threshold voltage.

8. The semiconductor device of any one of claims 1 to 5, wherein the first transistor and the second transistor have the same conductivity type, and the threshold voltage of the second transistor is higher than that of the first transistor.

9. The semiconductor device of claim 8, wherein the first gate insulating layer pattern is thinner than the second gate insulating layer pattern.

10. The semiconductor device of any one of claims 1 to 9, wherein the gate metal patterns of the first and second transistors comprise a conductive pattern and a barrier pattern.

11. The semiconductor device of claim 10, wherein the conductive pattern comprises Al.

12. The semiconductor device of any one of claims 1 to 11, further comprising a first fin formed in the first region and a second fin formed in the second region, wherein the first and second transistors are on the first and second fins, respectively.

13. A semiconductor device comprising:
a semiconductor substrate comprising a first region and a second region; and
first and second transistors having the same conductivity type and on the first and second regions, respectively,
wherein the first transistor comprises a first gate insulating layer pattern, a first work function adjustment film pattern and a first gate metal pattern formed sequentially on the semiconductor substrate, the second transistor comprises a second gate insulating layer pattern, a second work function adjustment film pattern and a second gate metal pattern formed sequentially on the semiconductor substrate, wherein the first gate insulating layer pattern and the second gate insulating layer pattern have different thicknesses.

14. The semiconductor device of claim 13, wherein a concentration of a metal contained in the first gate insulating layer pattern to adjust a threshold voltage of the first transistor is different from a concentration of the metal contained in the second gate insulating layer pattern to adjust a threshold voltage of the second transistor.

15. The semiconductor device of claim 13 or 14, further comprising a third transistor on a third region of the semiconductor substrate, wherein the third transistor comprises a third gate insulating layer pattern, a third work function adjustment film pattern and a third gate metal pattern formed sequentially on the semiconductor substrate, wherein a thickness of the third gate insulating layer pattern is different from the thicknesses of the first and second gate insulating layer patterns.

16. The semiconductor device of claim 15, wherein a concentration of the metal contained in the third gate insulating layer pattern to adjust a threshold voltage of the third transistor is different from the concentration of the metal contained in each of the first and second gate insulating layer patterns to adjust the threshold voltage of each of the first and second transistors.

17. The semiconductor device of claim 15 or 16, wherein a conductivity type of the third transistor is the same as those of the first and second transistors, the threshold voltage of the third transistor is higher than that of the second transistor, and the threshold voltage of the second transistor is higher than that of the first transistor.

18. The semiconductor device of claim 15 or 16, wherein the conductivity type of the third transistor is different from those of the first and second transistors, the threshold voltage of the third transistor is the same as that of the second transistor, and the threshold voltage of the second transistor is higher than that of the first transistor.

19. A semiconductor device comprising:
a semiconductor substrate comprising a first region and a second region;
a first transistor on the first region comprising a first gate insulating layer pattern; and
a second transistor on the second region comprising a second gate insulating layer pattern,
wherein a concentration of a metal in the second gate insulating layer pattern is higher than a concentration of metal in the first gate insulating layer pattern.
wherein the first and second transistors both further comprise a work function adjustment film pattern and a gate metal pattern, the work function adjustment film pattern of the first transistor being patterned from a same layer as the work function adjustment film pattern of the second transistor and the gate metal pattern of the first transistor being patterned from a same layer as the gate metal pattern of the second transistor.

20. The semiconductor device of claim 19, wherein the metal does not exist in the first gate insulating layer pattern and exists in the second gate insulating layer pattern.

21. A method of fabricating a semiconductor device, the method comprising:
providing a semiconductor substrate which comprises first, second and third regions and first, second and third gate insulating layers which are on the first, second and third regions, respectively;
forming a first diffusion prevention film, which exposes the second and third gate insulating layers, on the semiconductor substrate;
sequentially forming a first diffusion film, which comprises a metal oxide, and a first protection film on the semiconductor substrate;
diffusing a metal contained in the first diffusion film to the second and third gate insulating layers by performing a first heat treatment process on the semiconductor substrate;
removing the first diffusion film, the first protection film and the first diffusion prevention film;
forming a second diffusion prevention film, which exposes the third gate insulating layer, on the semiconductor substrate;
sequentially forming a second diffusion film, which comprises a metal oxide, and a second protection film on the semiconductor substrate; and
diffusing a metal contained in the second diffusion film to the third gate insulating layer by performing a second heat treatment process on the semiconductor substrate.

22. The method of claim 21, wherein the first and second diffusion prevention films comprise a metal oxide.

23. The semiconductor device of claim 21 or 22, wherein the first and second protection films prevent oxidation of the first and second diffusion films during the first and second heat treatment processes.

24. A method of fabricating a semiconductor device, the method comprising:
providing a semiconductor substrate which comprises first, second and third regions and first, second and third gate insulating layers which are on the first, second and third regions, respectively;
forming a diffusion prevention film, which exposes the second and third gate insulating layers, on the semiconductor substrate;
sequentially forming a diffusion film, which comprises a metal oxide, and a protection film on the semiconductor substrate; and
diffusing a metal contained in the diffusion film to the second and third gate insulating layers by heat-treating the semiconductor substrate,
wherein a first thickness of the diffusion film on the second gate insulating layer is different from a second thickness of the diffusion film on the third gate insulating layer.

25. The method of claim 24, wherein the second thickness is greater than the first thickness.

26. The method of claim 24 or 25, wherein a concentration of the metal diffused to the second gate insulating layer is smaller than that of the metal diffused to the third gate insulating layer.

27. A method of fabricating a semiconductor device, the method comprising:
providing a first transistor comprising a first gate insulating layer pattern, a first work function adjustment film pattern and a first gate metal pattern and having a first threshold voltage;
providing a second transistor comprising a second gate insulating layer pattern, a second work function adjustment film pattern which comprises same material as the first work function adjustment film pattern and a second gate metal pattern;
determining an amount of metal that should be diffused to the second gate insulating layer pattern in order to adjust a threshold voltage of the second transistor; and
adjusting the threshold voltage of the second transistor by masking the first gate insulating layer pattern and then diffusing the determined amount of metal only to the second gate insulating layer pattern through a heat treatment process.

28. The method of claim 27, further comprising:
measuring an initial threshold voltage of the second transistor; and
determining a target threshold voltage of the second transistor,
wherein the determining of the amount of metal that should be diffused to the second gate insulating layer pattern comprises determining the amount of metal that should be diffused to the second gate insulating layer pattern in order to adjust the threshold voltage of the second transistor from the initial threshold voltage to the target threshold voltage.
